# EUROPEAN PATENT APPLICATION

(11) **EP 2 891 839 A1**
(43) Date of publication of application: **08.07.2015**
(21) Application number: 14197647.2
(22) Date of filing: 12.12.2014
(51) Int. Cl.: F16M 11/22, F16M 13/02, G09F 15/00

(54) **Mounting fixture for a digital menu board**

(30) Priority: 19.12.2013 US 201361918415 P
(71) Applicant: Peerless Industries, Inc., Aurora IL 60502 (US)
(72) Inventor: Lewis, Charles W, Chicago, IL 60660 (US)
(74) Representative: Braddon, Nicholas

(57) **Abstract**

A mounting fixture (101) comprising a support post (103) configured to support the mounting fixture (101), a beam (104) coupled to the support post (103), and at least one cabinet assembly (105) coupled to and supported by the beam (104). Each audio/visual device is detachably coupled to a cabinet assembly (105). At least one sidekick (106) is coupled to a side of the at least one cabinet assembly (105) and extending laterally beyond an end of the beam (104). Each sidekick (106) includes at least one hook (164) configured to retain at least one graphic.

## Description

### BACKGROUND

This application relates generally to the field of fixtures for mounting and displaying attached devices. More specifically, this application relates to mounting fixtures for digital menu boards for mounting and displaying attached audio/visual devices.

### SUMMARY

One embodiment disclosed herein relates to a mounting fixture, such as, for example, for a digital menu board including at least one audio/visual device and at least one graphic. The mounting fixture includes a support post configured to support the mounting fixture, a beam coupled to the support post, at least one cabinet assembly coupled to and supported by the beam, and at least one sidekick coupled to a side of the at least one cabinet assembly. The at least one audio/visual device is detachably coupled to the at least one cabinet assembly. The at least one sidekick is coupled to a side of the at least one cabinet assembly and extends laterally beyond an end of the beam. Each sidekick includes at least one hook configured to retain the at least one graphic.

Another embodiment disclosed herein relates to a mounting fixture including at least one audio/visual device and at least one graphic coupled thereto. The mounting fixture includes a support post configured to support the mounting fixture, a beam coupled to the support post, at least one cabinet assembly coupled to and supported by the beam, wherein the at least one audio/visual device is detachably coupled to the at least one cabinet assembly, and a topper coupled to an upper portion of the at least one cabinet assembly and extending upwardly therefrom. The topper includes at least one hook configured to retain the at least one graphic. The topper may include a right-side topper and a left-side topper, where the right-side topper includes at least one hook for retaining a first graphic, and wherein the left-side topper includes at least one hook for retaining a second graphic.

### BRIEF DESCRIPTION OF THE DRAWINGS

Figure 1 is an isometric view of an exemplary embodiment of a mounting fixture.
Figure 2 is a front elevational view of the fixture of Figure 1.
Figure 3 is a top plan view of the fixture of Figure 1.
Figure 4 is a side elevational view of the fixture of Figure 1.
Figure 5 is an exploded front elevational view of the fixture of Figure 1.
Figure 6 is an isometric view of an exemplary embodiment of a support post for use with the mounting fixture of Figure 1.
Figure 7 is a top plan view of the support post of Figure 6.
Figure 8 is a front elevational view of the support post of Figure 6.
Figure 9 is an isometric view of an exemplary embodiment of a beam assembly for use with the mounting fixture of Figure 1.
Figure 10 is a top plan view of the beam assembly of Figure 9.
Figure 11 is a bottom plan view of the beam assembly of Figure 9.
Figure 12 is a side elevational view of the beam assembly of Figure 9.
Figure 13 is a front isometric view of an exemplary embodiment of a cabinet assembly for use with the mounting fixture of Figure 1.
Figure 14 is a rear isometric view of the cabinet assembly of Figure 13.
Figure 15 is a front elevational view of the cabinet assembly of Figure 13.
Figure 16 is a rear elevational view of the cabinet assembly of Figure 13.
Figure 17 is a top plan view of the cabinet assembly of Figure 13.
Figure 18 is a cross-sectional view of the cabinet assembly of Figure 13 taken along line D-D of Figure 16.
Figure 19 is an isometric view of an exemplary embodiment of a right sidekick for use with the mounting fixture of Figure 1.
Figure 20 is a front elevational view of the right sidekick of Figure 19.
Figure 21 is a side elevational view of the right sidekick of Figure 19.
Figure 22 is a top plan view of the right sidekick of Figure 19.
Figure 23 is an isometric view of an exemplary embodiment of a left sidekick for use with the mounting fixture of Figure 1.
Figure 24 is a front elevational view of the left sidekick of Figure 23.
Figure 25 is a side elevational view of the left sidekick of Figure 23.
Figure 26 is a top plan view of the left sidekick of Figure 23.
Figure 27 is an isometric view of an exemplary embodiment of a right-side topper for use with the mounting fixture of Figure 1.
Figure 28 is a front elevational view of the right-side topper of Figure 27.
Figure 29 is a side elevational view of the right-side topper of Figure 27.
Figure 30 is a detail view of the right-side topper of Figure 29.
Figure 31 is an isometric view of an exemplary embodiment of a left-side topper for use with the mounting fixture of Figure 1.
Figure 32 is a front elevational view of the left-side topper of Figure 31.
Figure 33 is a side elevational view of the left-side topper of Figure 31.
Figure 34 is a detail view of the left-side topper of Figure 33.
Figure 35 is an isometric view of an exemplary embodiment of a gusset for use with the mounting fixture of Figure 1.
Figure 36 is a side elevational view of the gusset of Figure 35.
Figure 37 is a front elevational view of the gusset of Figure 35.
Figure 38 is a top plan view of the gusset of Figure 35.
Figure 39 is a plan view of a blank for making the gusset of Figure 35.

### DETAILED DESCRIPTION

Referring generally to the Figures, disclosed in this application are mounting fixtures for digital menu boards including cabinet assemblies having audio/visual devices, which may be integrated with the fixtures, and at least one sidekick configured to retain a graphic thereto and/or at least one topper configured to retain a graphic thereto. For example, each sidekick may extend laterally from a side of a cabinet assembly, such that the graphics retained by the sidekick may be used along with, such as to complement, information displayed by the one or more audio/visual devices of the one or more cabinet assemblies. Also, for example, topper may extend upwardly from a top of at least one cabinet assembly, such that the graphics retained by the topper may be used along with, such as to complement, information displayed by the one or more audio/visual devices of the one or more cabinet assemblies.

It is noted that although the Figures may include specific dimensional values for various features/elements/aspects of the mounting fixture, these specific dimensional values are only exemplary and are not limiting in any way.

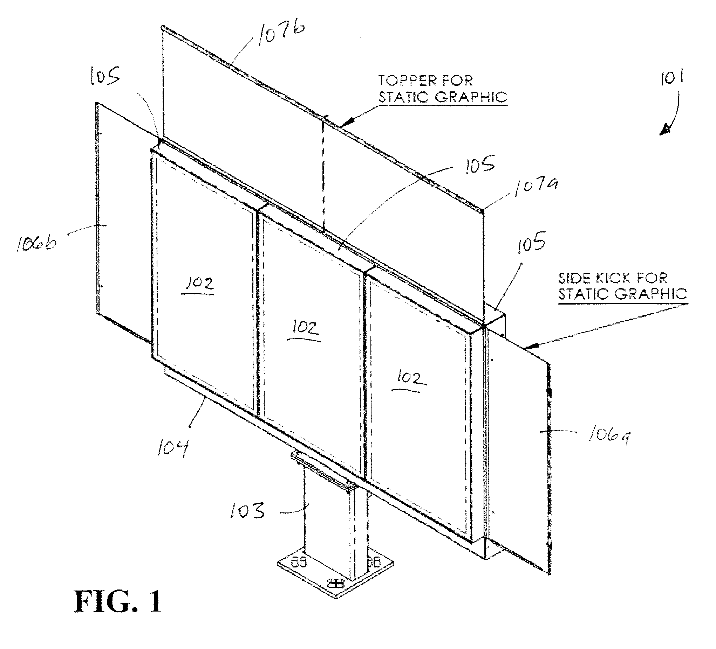

Figures 1-5 illustrate an exemplary embodiment of a mounting fixture 101 (e.g., a support, fixture, support structure, etc.) configured to support an audio/visual device (e.g., a monitor, a ciil® TV, display, speaker, etc.) detachably coupled thereto. As shown, three monitors 102 are detachably coupled to the mounting fixture 101. However, the mounting fixture 101 can be configured to support a greater number or a fewer number of monitors 102 detachably coupled thereto.

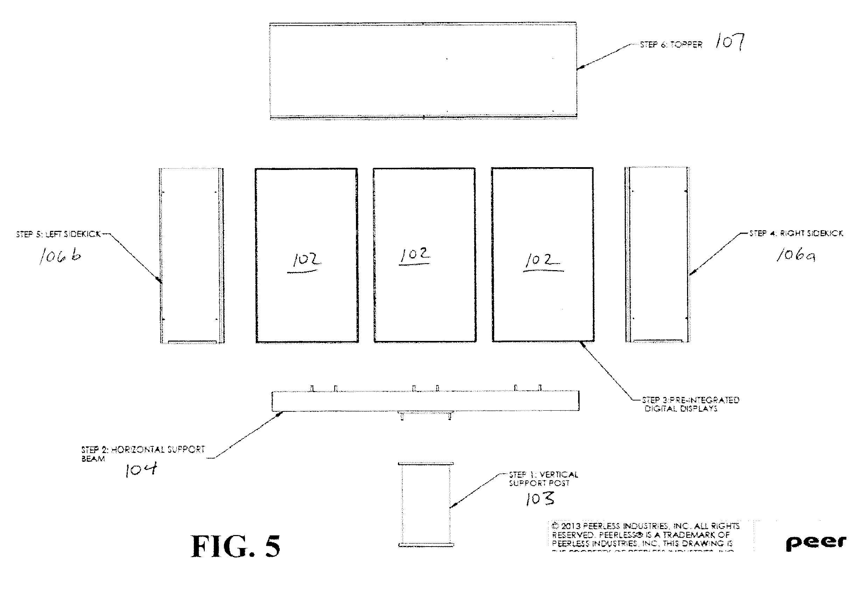

The mounting fixture 101 may include one or more elements or members coupled together to form a structure for supporting the audio/visual devices used with the fixture. As shown in Figure 5, the mounting fixture 101 includes a support post 103, a beam 104 (e.g., support beam), and at least one cabinet assembly 105. The support post 103 may extend generally in a vertical direction from a mounting location to support the beam 104 coupled thereto. The beam 104 may extend generally in a horizontal direction to support the one or more cabinet assemblies 105 coupled to the beam 104.

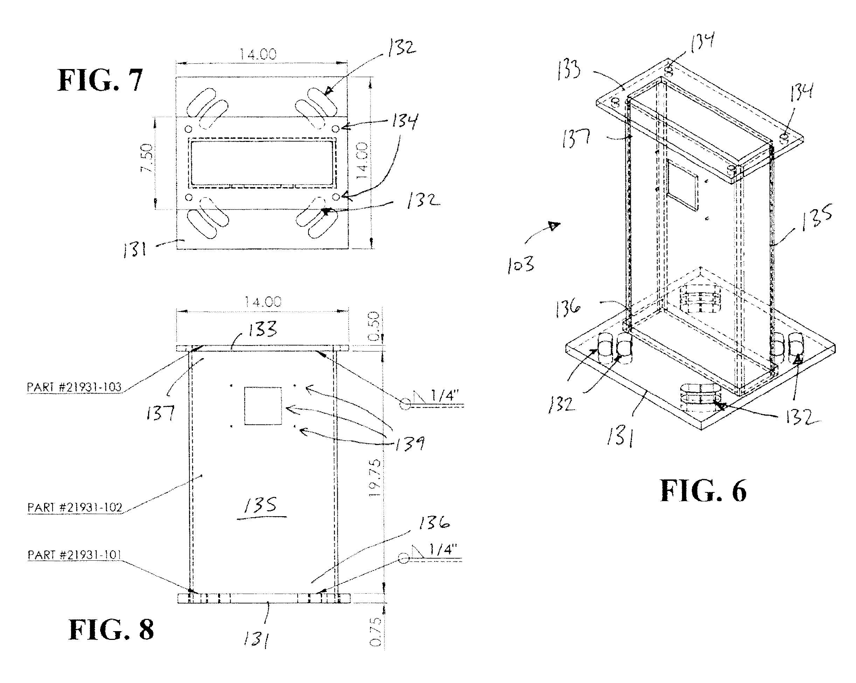

Figures 6-8 illustrate an exemplary embodiment of a support post 103. The support post 103 may be configured to detachably couple to another object (e.g., a foundation, the ground, a fixture, a support, etc.). As shown, the support post 103 includes a base 131 (e.g., a base member) in the form of a plate that includes a plurality of apertures 132 for coupling the base 131 to the other object. The base 131 may be generally square, as shown, or may be rectangular, circular, or may have any suitable configuration (e.g., shape, size, etc.). The base 131 may include eight apertures 132, as shown, or may include a greater number or a fewer number of apertures. Each aperture 132 may be arcuate in shape, circular, elliptical, or may have any suitable shape.

The support post 103 also includes an upper member 133 that is configured to support the beam 104 detachably coupled thereto. The upper member 133 may be in the form of a plate that includes a plurality of apertures 134 for facilitating coupling of the beam 104 thereto. The upper member 133 may be generally square, as shown, rectangular, circular, or may have any suitable configuration (e.g., shape, size, etc.). The upper member 133 may include four apertures 134, as shown, or may include a greater number or a fewer number of apertures. Each aperture 134 may be arcuate in shape, circular, elliptical, or may have any suitable shape.

The support post 103 may also include a body 135 disposed between the base 131 and the upper member 133. The body 135 may include a first end 136 that is coupled to the base 131 and a second end 137 that is coupled to the upper member 133. The body 135 may have an elongated shape (e.g., a height greater than its width and/or depth) with a closed cross-section, such as generally rectangular (i.e., rectangular or rectangular with rounded corners), or an open cross-section (e.g., a C-shape, a U-Shape, etc.). The body 135 may be configured differently, such as, for example, having a width and/or depth that is greater than its height, or may have any suitable cross-section that is able to support the loading of the mounting fixture 101. The base 131, the upper member 133, and the body 135 may be integrally formed or formed separately then coupled together using any suitable process (e.g., welding) that is able to couple the members together with sufficient strength for withstanding the requisite loading conditions. Figure 8 illustrates an exemplary welding process utilizing a first filet weld around the entire first end 136 of the body 135 and the base 131, and a second fillet weld around the entire second end 137 and the upper member 133. It is noted that other suitable processes, including other welding processes may be utilized. For example, the welds may be discontinuous around the ends.

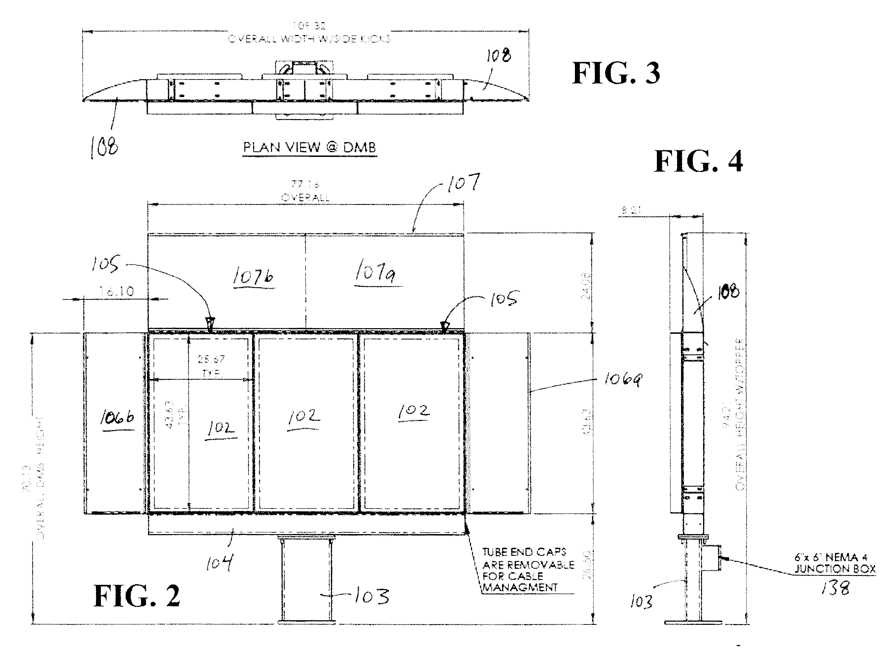

The mounting fixture 101 may include a junction box that is configured to house other components, such as electronic/electrical components that provide electric power or service to the audio/visual devices coupled to the fixture. As shown in Figure 4, the mounting fixture 101 includes a junction box 138 that is coupled to a backside of the body 135 of the support post 103. The junction box 138 may have a generally open or hollow polyhedral (e.g., cuboid) shape to house the electrical components within the box 138 or between the box 138 and the support post 103, such as to protect the housed components from the external elements (e.g., weather) or inadvertent damage. The junction box 138 may be configured to detachably couple to the support post 103, such as through fasteners (e.g., screws, bolts, snaps, etc.). The support post 103 may include features to facilitate coupling the junction box 138 thereto. For example, the support post 103 may include one or more apertures 139 (as shown in Figure 8) configured to receive fasteners to couple the junction box 138 to the support post 103. When multiple apertures 139 are provided, the apertures 139 may be similarly or differently sized.

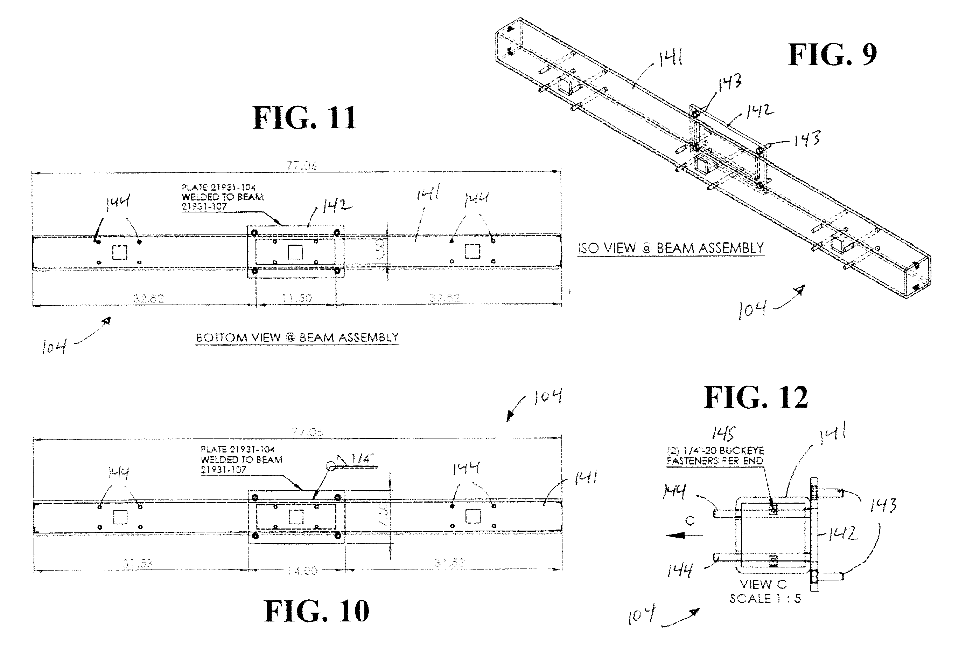

Figures 9-12 illustrate an exemplary embodiment of a beam 104 (e.g., beam assembly). The beam 104 may be configured to detachably couple to another component of the mounting fixture 101, such as the support post 103 and/or one or more cabinet assemblies 105. As shown, the beam 104 includes an elongated body 141 having a generally square (i.e., square or square with rounded corners) cross-section that is hollow. In other words the body 141 may be configured as a tubular member, or may have other suitable configurations (e.g., open cross-section, rectangular shape, etc.). The body 141 has a length that may be tailored to the width of the one or more cabinet assemblies 105 to be supported by the beam 104. Thus, the length of the beam 104 may be shorter for fixtures having fewer than three monitors 102 or may be longer for fixtures having greater than three monitors 102. The configuration of the beam, such as cross-sectional shape, thickness, and/or material may be tailored to the number of monitors 102 carried by the fixture.

The beam 104 includes features to facilitate coupling of the beam 104 to the support post 103 and the one or more cabinet assemblies 105 to the beam 104. As shown, the beam 104 includes a mounting plate 142 coupled to a bottom surface of the body 141, where the mounting plate 142 includes a plurality of fasteners 143 that detachably couple the beam 104 and support post 103 together. The mounting plate 142 has a top surface, which may abut the bottom surface of the body 141, and a bottom surface, which may abut a top surface of the upper member 133 of the support post 103. The mounting plate 142 may be in the form of a plate, the configuration of which may be tailored to the configuration of the upper member 133. For example, the mounting plate 142 may include four fasteners 143 provided in a rectangular arrangement, such that each fastener 143 engages one aperture 134 in the upper member 133. The mounting plate 142 may be integrally formed or formed separately then coupled to the body 141 using any suitable process (e.g., welding) capable of providing the beam 104 with sufficient strength for withstanding the requisite loading conditions. Figure 10 illustrates an exemplary welding process utilizing a first filet weld around the entire mating top surface of the mounting plate 142 and the bottom surface of the body 141. It is noted that other suitable processes, including other welding processes may be utilized. For example, the welds may be discontinuous around the plate and the body.

As shown, the feature for coupling each cabinet assembly 105 to the beam 104 includes a set of studs 144 that extend (e.g., protrude) beyond a top surface of the body 141. The coupling feature may include a fewer or greater number of studs 144 to couple the cabinet assembly 105 and beam 104 together. Each stud 144 may extend through the body 141. As shown in Figure 12, each stud 144 extends through both an upper portion (e.g., upper wall) and a lower portion (e.g., lower wall) of the body 141, such that each stud 144 may be in double shear if shear loads are introduced into the fixture. Alternatively, each stud 144 may extend only through a single portion (e.g., the upper portion) of the body 141. As shown, four studs may be provided having a generally rectangular arrangement. Each stud 144 may include threads, such as, for example, on an end thereof to thread to a nut or other fastener. The body 141 may include an opening, such as, for example, within the set of studs 144, which may provide access for routing of other elements (e.g., electrical wiring).

The beam 104 may include any number of coupling features for coupling any number of cabinet assemblies 105 to the beam 104. For example, the beam 104 may include three sets of coupling features that are spaced apart by a common distance (e.g., a common spacing). However, the spacing distance of the adjacent coupling features (for coupling the adjacent cabinet assemblies) may be differently configured.

The beam 104 may include an end cap configured to engage an end of the body 141. For example, the beam 104 may include two end caps, with one end cap engaging each end of the tubular body 141. The beam 104 may further include one or more fasteners for attaching each end cap to the body 141. As shown in Figure 12, a fastener 145 is provided on each of the opposing side walls of the body 141, where the fasteners 145 couple an end cap to the body 141 to cover the opening in the end of the body 141.

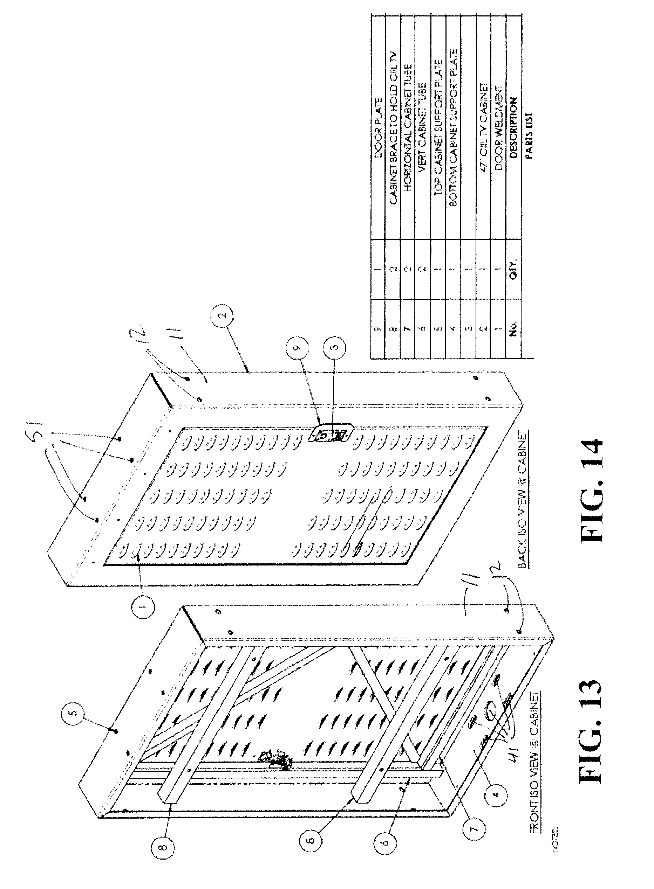

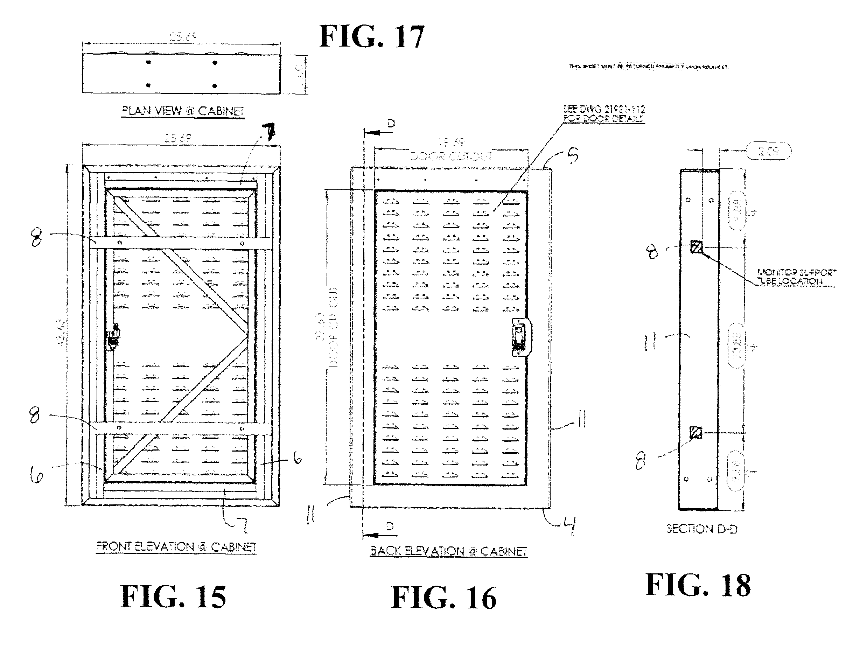

Figures 13-18 illustrate an exemplary embodiment of a cabinet assembly 105 configured to house an audio/visual device therein, such as a monitor 102. As shown in Figures 13 and 14, the cabinet assembly 105 includes a door 1 and a cabinet 2. The door 1 may be configured to move (e.g., rotate or pivot) relative to the cabinet 2, such as to provide access to an inner cavity of the cabinet 2 housing a monitor 102. For example, the door 1 may be pivotally coupled to the cabinet 2 via one or more than one hinge.

The cabinet 2 may include one or more members that are coupled together to define a polyhedron shaped component having a cavity for receiving an audio/visual device therein. As shown, the cabinet 2 includes a bottom member 4 (e.g., the bottom cabinet support plate), a top member 5 (e.g., the top cabinet support plate), and a pair of opposing side members 11 that together form a cuboid outer frame having a generally cuboid cavity. The members 4, 5, 11 of the cabinet 2 may be integrally formed or formed separately then coupled together. The outer frame may have an opening, such as at a front opening and/or a rear opening of the cabinet 2. The rear opening may be configured to be selectively closed-off by the door 1. The front opening may be configured to allow an output (e.g., display, information, etc.) therethrough, such as from an audio/visual device housed in the cabinet 2. The cabinet 2 may further include a protective layer, such as a screen or cover (e.g., a transparent cover), which may help protect the audio/visual device from damage. For example, a transparent cover may be contained by one or more flanges of the cabinet 2 (e.g., a flange of the top member, a flange of the bottom member, and/or a flange from one or more side members) between the audio/visual device housed in the cabinet 2 and the flange(s).

The bottom member 4 may include a feature for coupling the cabinet 2 to another component of the fixture, such as the beam 104. As shown in Figure 13, the bottom member 4 includes a plurality of apertures 41 that are configured to receive the studs 144 of the beam 104. Further apertures 41 may be provided in the bottom member 4, such as to provide access for routing other components, such as a wiring harness or electrical components from the cabinet 2 to the beam 104.

The top member 5 may include a feature for coupling the cabinet 2 to another component of the fixture, such as a topper (e.g., right-side topper 107a, left-side topper 107b) if provided. As shown in Figure 14, the top member 5 includes a plurality of apertures 51 that are configured to facilitate coupling of the topper to the top member 5.

Each side member 11 may include a feature for coupling the cabinet 2 to another component of the fixture, such as another cabinet 2 and/or a sidekick (e.g., a right sidekick 106a, a left sidekick 106b), if provided. As shown in in Figures 13 and 14, each side member 11 may include a plurality of apertures 12 disposed at an upper portion of the side member 11 and a plurality of apertures 12 disposed at a lower portion of the side member 11, where all or a portion of the plurality of apertures may be used to couple another component of the fixture to the side member 11.
The cabinet 2 may also include one or more than one brace or support members, such as to provide structural support to the cabinet 2 and/or to help retain an object, such as an audio/visual device. As shown in Figure 13, the cabinet 2 includes a tube 6 (e.g., vertical cabinet tube) that extends vertically between the top member 5 and the bottom member 4. The cabinet 2 may include more than one tube 6, such as a pair of spaced apart tubes 6. A first tube 6 may be provided adjacent to or abutting one side member 11 and a second tube 6 may be provided adjacent to or abutting the other side member 11. As shown in Figure 13, the cabinet 2 includes a horizontal tube 7 (e.g., a horizontal cabinet tube). The cabinet 2 may include more than one horizontal tube 7. Each tube 7 may be configured to extend between two tubes 6, between a tube 6 and a side member 11, or between two side members 11. The tubes 6, 7 may be interconnected (e.g., coupled together), such as to increase the strength of the frame. As shown in Figure 13, the cabinet 2 includes a pair of spaced apart braces 8 that extend between the side members 11 to support the audio/visual device installed into the cabinet 2. Alternatively, each brace 8 may extend between a side member 11 and a tube (e.g., a vertical tube 6) or between two tubes. Each brace 8 may be coupled directly to a side member 11 and/or a tube. Each brace 8 may be configured to support the backside of the audio/visual device, such that the device is held between the front of the cabinet 2 (and/or a protective layer in the front opening thereof) and the brace 8.

The cabinet 2 and/or the door 2 may include a feature that is configured to limit travel of the door 1 relative to the cabinet 2. As shown in Figure 14, the door 1 includes a door plate 9 that is configured to contact the cabinet 2, such as a portion of a side member 11, when the door 1 is in a closed position to thereby limit travel of the door 1 relative to the cabinet 2. When the door 1 is in an open position, the door plate 9 may be utilized to close the door 1. The door plate 9 may include a portion (e.g., a lip) that overhangs the portion of the side member 11, such that the lip contacts the side member 11 when the door 1 is closed.

The cabinet 2 and/or the door 2 may include a feature that is configured to selectively lock the door 1 relative to the cabinet 2. As shown in Figure 14, a lock mechanism 3 is provided between the door 1 and cabinet 2 to lock the door 1 in the closed position. The lock mechanism 3 may be configured similar to a conventional door locking mechanism, where a key may be utilized to selectively lock the lock mechanism 3. Thus, the lock mechanism may be adjustable between locking and unlocking conditions (e.g., operations).

The mounting fixture 101 may include more than one cabinet assembly 105, such as to house more than one audio/visual devices. As shown in Figure 1, the mounting fixture 101 includes three cabinet assemblies 105 provided in a side-by-side arrangement, where each cabinet assembly 105 is configured to house one monitor 102. Thus, the fixture 101 shown includes three monitors 102 provided in a side-by-side arrangement.

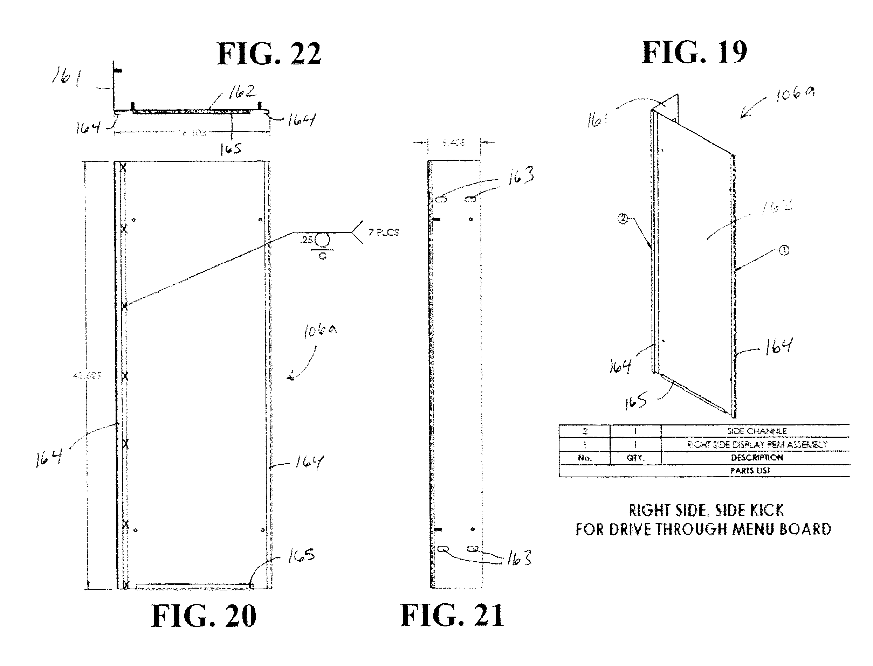

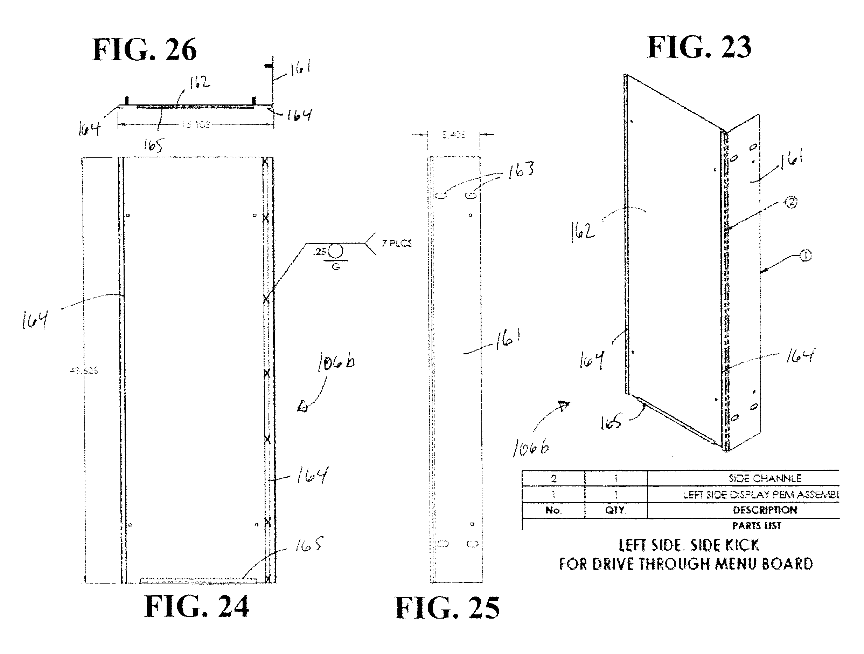

The mounting fixture 101 may also include a sidekick 106 that is configured to carry (e.g., receive, support, etc.) a graphic (e.g., other visual device) used with the fixture. According to an exemplary embodiment, a magnetic static graphic may be coupled to the sidekick 106 via magnetism. Figures 19-22 illustrate an exemplary embodiment of a right sidekick 106a, which is configured to detachably couple to an adjacent cabinet assembly 105 (as shown in Figure 1). Figures 23-26 illustrate an exemplary embodiment of a left sidekick 106b, which is configured to detachably coupled to an adjacent cabinet assembly 105 that may be different than the cabinet assembly 105 to which the right sidekick 106a is attached (as shown in Figure 1).

As shown in Figure 19, the right sidekick 106a has a mounting member 161 and a receiving member 162. The mounting member 161 is configured to couple the sidekick 106 to the fixture, such as to an adjacent cabinet assembly 105. The receiving member 162 is configured to receive a graphic. The mounting and receiving members 161, 162 may together have a generally L-shaped cross-section (when viewed from above as shown in Figure 22), such as, for example, where the mounting member 161 forms the base of the L-shape and the receiving member 162 forms the leg of the L-shape. The mounting member 161 may include a feature for detachably coupling the mounting member 161 to the cabinet assembly 105, such as a side member 11 of a cabinet 2. As shown in Figure 21, the mounting member 161 includes a plurality of apertures 163 for coupling the mounting member 161 to the cabinet assembly 105. The plurality of apertures 163 may include a pair of slots provided at an upper portion of the mounting member 161 and a pair of slots provided at a lower portion of the mounting member 161. The plurality of apertures 163 may be configured differently than shown.

The sidekick 106 may include a feature that is configured to help retain the graphic attached thereto. For example, the sidekick may include one or more than one hook (e.g., finger, arm, etc.) that defines a channel to receive a portion of the graphic therein. As shown in Figures 19, 20, and 22, the receiving member 162 includes a pair of opposing side hooks 164, where each hook 164 extends away from a face (e.g., a front face) of the receiving member 162 and along a side of the receiving member 162. Each side hook 164 may be generally J-shaped, such that a channel is defined by each hook 164. Each channel is accessible by the open end of each hook 164. As shown, the open sections or channels of the opposing hooks 164 may be provided in opposing arrangement, such that a side portion of the graphic may be retained by each hook 164 in its respective channel. The side hooks 164 may also limit movement of the graphic in lateral directions (e.g., side-to-side directions) beyond the side hooks 164. Also shown, the receiving member 162 includes a lower hook 165 that extends away from the face of the receiving member 162 and along a bottom portion (e.g., a bottom edge) of the receiving member 162. The lower hook 165 may be generally J-shaped, such that an upward facing channel is formed at an open end of the hook 165. The lower hook 165 may be configured to retain a bottom portion of the graphic to limit movement of the graphic in a downwardly direction beyond the lower hook 165.

The right sidekick 106a may include additional hooks, such as provided on the opposite face (e.g., a rear face) to retain a second graphic provided on the opposite face. This arrangement is for a fixture displaying graphics on both faces of the sidekick.

According to the exemplary embodiment shown in Figures 23-26, the left sidekick 106b is configured to be symmetrically opposite to the right sidekick 106a. Therefore, the elements constituting the left sidekick 106b have been given the same reference numerals as the corresponding symmetric element of the right sidekick 106a. According to another exemplary embodiment, the left sidekick 106b may be configured identical to the right sidekick 106a.

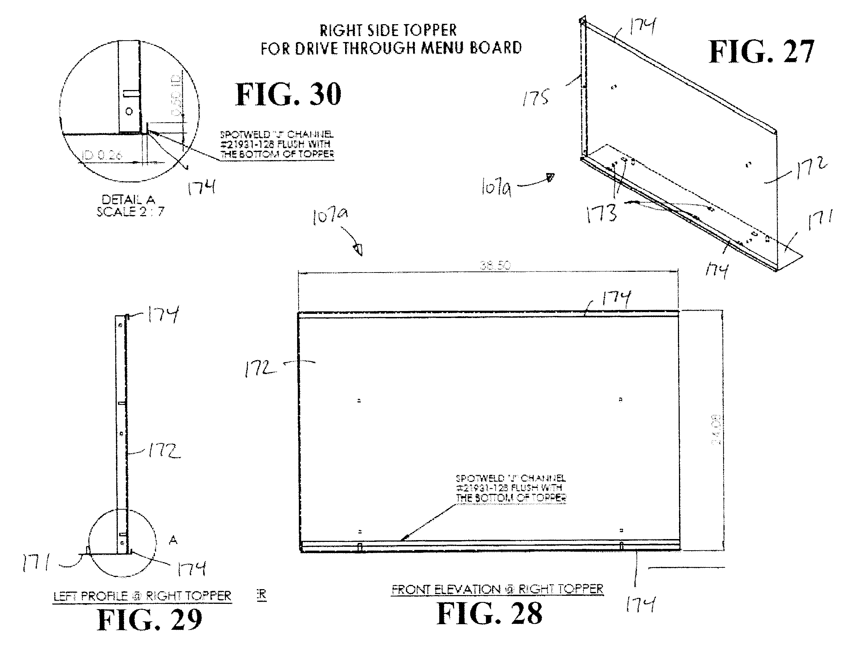

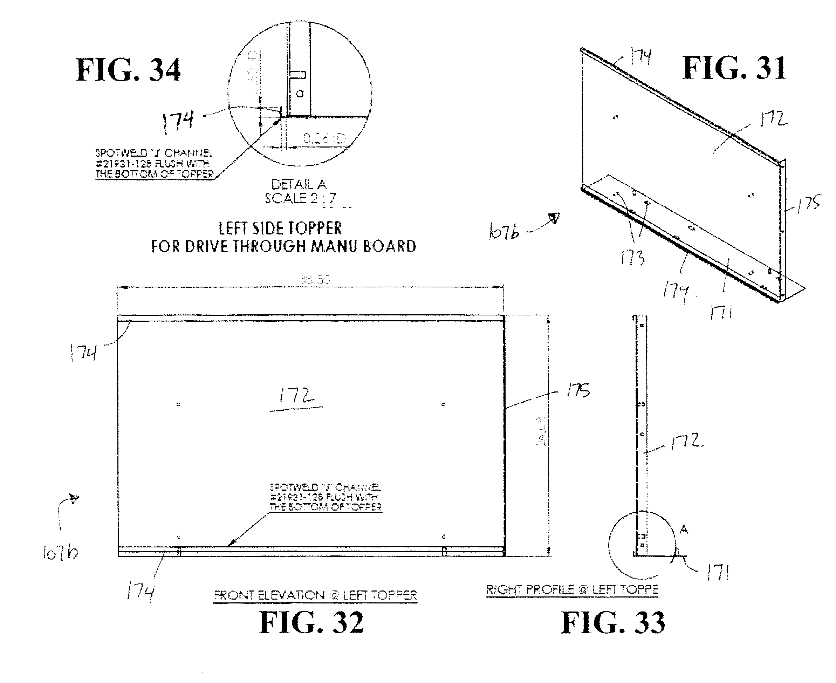

The mounting fixture 101 may also include a topper 107 that is configured to carry (e.g., receive, support, etc.) a graphic (e.g., other visual device) used with the fixture. According to an exemplary embodiment, a magnetic static graphic may be coupled to the topper 107 via magnetism. Figures 27-30 illustrate an exemplary embodiment of a right-side topper 107a, which is configured to be detachably coupled to an adjacent portion of at least one cabinet assembly 105 (as shown in Figure 1), such as a top member 5. Figures 31-34 illustrate an exemplary embodiment of a left-side topper 107b, which is configured to be detachably coupled to an adjacent portion of at least one cabinet assembly 105.

As shown in Figure 27, the right-side topper 107a includes a mounting member 171 and a receiving member 172. The mounting member 171 is configured to couple the right-side topper 107a to the fixture, such as to an adjacent cabinet assembly 105. The receiving member 172 is configured to receive a graphic. The mounting and receiving members 171, 172 may together have a generally L-shaped cross-section (when viewed from a side as shown in Figure 29), such as, for example, where the mounting member 171 forms the base of the L-shape and the receiving member 172 forms the leg of the L-shape. The mounting member 171 may include a feature for detachably coupling the mounting member 171 to the cabinet assembly 105, such as a top member 5 of a cabinet 2. As shown in Figure 27, the mounting member 171 includes a plurality of apertures 173 for coupling the mounting member 171 to the cabinet assembly 105. The plurality of apertures 173 may include both laterally extending and fore-and-aft (e.g., front to back) extending slots to provide adjustability in both directions (e.g., lateral and fore-and-aft). The plurality of apertures 173 may be configured differently than shown.

The topper 107 may include a feature that is configured to help retain the graphic attached thereto. For example, the topper may include one or more than one hook (e.g., finger, arm, etc.) that defines a channel to receive a portion of the graphic therein. As shown in Figures 27-30, the receiving member 172 includes a pair of opposing hooks 174, where the hooks 174 extend away from a face (e.g., a front face) of the receiving member 172 and along opposing top and bottoms edges of the receiving member 172. Each hook 174 may be generally J-shaped, such that a channel is defined by each hook 174. Each channel is accessible by the open end of each hook 174. As shown, the open sections or channels of the opposing hooks 174 may be provided in opposing arrangement, such that a portion of the graphic may be retained by each hook 174 in its respective channel. The hooks 174 may also limit movement of the graphic in the directions beyond the hooks 174.

The receiving member 172 may include a side feature that limits movement of the graphic laterally beyond the side feature. As shown, the side feature 175 is in the form of a wall that extends outwardly from the front face of the receiving member 172. Alternatively, the side feature of the receiving member 172 may be a side hook that extends away from the face of the receiving member 172 and along a side (e.g., a lateral edge) of the receiving member 172. The side hook 175 may be generally J-shaped having a side facing channel formed at an open end of the hook 175. The hook 175 may be configured to retain a side portion of the graphic to limit movement of the graphic in a direction beyond the hook 175.

The right-side topper 107a may include additional hooks, such as provided on the opposite face (e.g., a rear face) to retain a second graphic provided on the opposite face. This arrangement is for the fixture displaying graphics on both faces of the topper.

According to the exemplary embodiment shown in Figures 23-26, the left-side topper 107b is configured to be symmetrically opposite to the right-side topper 107a. Therefore, the elements constituting the left-side topper 107b have been given the same reference numerals as the corresponding symmetric element of the right-side topper 107a. According to another exemplary embodiment, the left-side topper 107b may be configured identical to the right-side topper 107a.

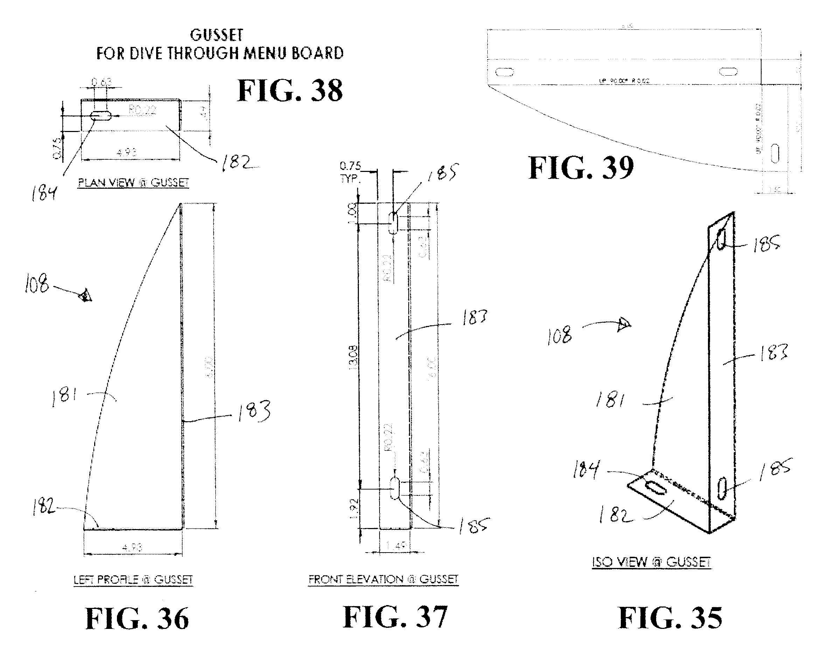

The mounting fixture 101 may also include one or more than one gusset 108 to couple each sidekick 106 and/or each topper 107 to the fixture. Figures 35-38 illustrate an exemplary embodiment of a gusset 108, and Figure 39 illustrates a blank for forming the gusset 108. As shown, the gusset 108 includes a face 181, a first wall 182, and a second wall 183. The first and second walls 182, 183 are provided at about a right angle (e.g., approximately 90 degrees) relative to each other, and the face 181 interconnects the first and second walls 182, 183 by extending in a transverse plane relative to the walls 182, 183. The first wall 182 is configured to be coupled to a first surface of a component of the fixture and the second wall 183 is configured to be coupled to a second surface of a component (which may be the same or a different component having the first surface). The first wall 182 may include one or more features to facilitate coupling the gusset 108 to another component of the fixture. As shown, the first wall 182 includes an opening 184 configured as a slot. However, the opening 184 may have any suitable configuration. The second wall 183 may include one or more features to facilitate coupling the gusset 108 to another component of the fixture. As shown, the second wall 184 includes a pair of spaced-apart openings 185 configured as slots. However, the openings 185 may have any suitable configuration. As shown in Figures 3 and 4, when provided, the gussets 108 may help strengthen the sidekick(s) 206 and the topper(s) 207 coupled to the mounting fixture 110, such as the one or more cabinet assemblies 105.

According to an exemplary embodiment, the mounting fixture 101 may be assembled using a six step method. The first step may include securing (e.g., bolting) the support post 103 (e.g., a vertical support post) to a foundation by placing the support post 103 over coupling features (e.g., ¾" diameter anchor bolts) in the foundation and, for example, tightening the bolts securely.

The second step may include placing the beam 104 (e.g., a horizontal support beam) on top of the support post 103 by sliding the fasteners 143 (e.g., ½" bolts) down through the apertures 134 (e.g., the top holes) of the upper member 133 of the support post 103. For example, ½" nuts, washers, and lock washers may optionally be provided and tightened over the fasteners 143 to secure the beam 104 and support post 103 together.

The third step may include mounting the one or more than one cabinet assemblies 105, including, for example, pre-integrated digital displays supported on a brace (e.g., brace 8) or tube (e.g., tube 7) by placing the bottom member 4 of the cabinet 2 over the plurality of studs 144 (e.g., (4) ½" threaded rods welded to the body 141) of the beam 104. For example, ½" nuts, washers, and lock washers may optionally be provided and tightened over the studs 144 to secure each cabinet assembly 105 to the beam 104. As noted above, the beam 4 can, for example, be configured to support multiple displays (e.g., 2-4 digital displays).

The fourth step may include mounting the right sidekick 106a, if provided, to the right side of right-most positioned cabinet assembly 105 including the pre-integrated digital display by matching the apertures 163 (e.g., slots) in the mounting member 161 of the right sidekick 106a to the apertures 12 in the cabinet assembly 105. For example, (4) ½" x 13 bolts and nuts, and (8) ½" sealing washers may be optionally provided and tightened to secure the right sidekick 106a to the cabinet assembly 105.

The fifth step may include mounting the left sidekick 106b, if provided, to the left side of the left-most positioned cabinet assembly 105 by matching the apertures 163 (e.g., slots) in the mounting member 161 of the left sidekick 106b to the apertures 12 in the cabinet assembly 105. For example, (4) ½" x 13 bolts and nuts, and (8) ½" sealing washers may optionally be provided and tightened to secure the left sidekick 106b to the cabinet assembly 105.

The sixth step may include mounting the topper 107 (e.g., the right-side topper 107a, the left-side topper 107b, etc.) to the top of at least one cabinet assembly 105 (but could be several or all of the cabinet assemblies) by matching the apertures 173 (e.g., slots) in the topper 107 to the apertures 51 (e.g., holes) in the at least one cabinet assembly 105. The apertures 51 in the at least one cabinet assembly 105 may be tapped as, for example, with 5/16"-18 holes. For example, (12) 5/16"-18 bolts and sealing washers may optionally be provided and tightened to secure the topper 107 to the cabinet assembly 105.

The assembly process of the mounting fixture 101 may vary from the exemplary process described above. For example, any combination of the fourth, fifth, and sixth steps may be omitted, such as when one or more of the sidekicks and/or toppers are not utilized on the mounting fixture.

As utilized herein, the terms "approximately," "about," "substantially", and similar terms are intended to have a broad meaning in harmony with the common and accepted usage by those of ordinary skill in the art to which the subject matter of this disclosure pertains. It should be understood by those of skill in the art who review this disclosure that these terms are intended to allow a description of certain features described and claimed without restricting the scope of these features to the precise numerical ranges provided. Accordingly, these terms should be interpreted as indicating that insubstantial or inconsequential modifications or alterations of the subject matter described and claimed are considered to be within the scope of the invention as recited in the appended claims.

It should be noted that the term "exemplary" as used herein to describe various embodiments is intended to indicate that such embodiments are possible examples, representations, and/or illustrations of possible embodiments (and such term is not intended to connote that such embodiments are necessarily extraordinary or superlative examples).

The terms "coupled," "connected," and the like as used herein mean the joining of two members directly or indirectly to one another. Such joining may be stationary (e.g., permanent) or moveable (e.g., removable or releasable). Such joining may be achieved with the two members or the two members and any additional intermediate members being integrally formed as a single unitary body with one another or with the two members or the two members and any additional intermediate members being attached to one another.

References herein to the positions of elements (e.g., "top," "bottom," "above," "below," etc.) are merely used to describe the orientation of various elements in the figures. It should be noted that the orientation of various elements may differ according to other exemplary embodiments, and that such variations are intended to be encompassed by the present disclosure.

It is important to note that the construction and arrangement of the modular moveable fixtures having modular frame structures as shown in the various exemplary embodiments are illustrative only. Although only a few embodiments have been described in detail in this disclosure, those skilled in the art who review this disclosure will readily appreciate that many modifications are possible (e.g., variations in sizes, dimensions, structures, shapes and proportions of the various elements, values of parameters, mounting arrangements, use of materials, colors, orientations, etc.) without materially departing from the novel teachings and advantages of the subject matter described herein. For example, elements shown as integrally formed may be constructed of multiple parts or elements, the position of elements may be reversed or otherwise varied, and the nature or number of discrete elements or positions may be altered or varied. The order or sequence of any process or method steps may be varied or re-sequenced according to alternative embodiments. Other substitutions, modifications, changes and omissions may also be made in the design, operating conditions and arrangement of the various exemplary embodiments without departing from the scope of the present invention.

## Claims

1. A mounting fixture (101) for a digital menu board including at least one audio/visual device and at least one graphic, comprising:
a support post (103) configured to support the mounting fixture (101);
a beam (104) coupled to the support post (103);
at least one cabinet assembly (105) coupled to and supported by the beam (104), wherein one of the at least one audio/visual device is detachably coupled to each of the at least one cabinet assembly (105); and
at least one of a sidekick (106), extending laterally beyond an end of the beam (104), and a topper (107), extending upwardly beyond the cabinet assembly (105),
wherein each of the at least one of the sidekick (106) and the topper (107) is coupled to the cabinet assembly (105) and includes at least one hook (164) configured to retain the at least one graphic.

2. The mounting fixture of claim 1, wherein the at least one of the sidekick (106) and the topper (107) includes a sidekick (106) coupled to a side of the cabinet assembly (105), and wherein the sidekick (106) also extends laterally beyond the cabinet assembly (105).

3. The mounting fixture of claim 2, wherein the at least one sidekick (106) includes a right sidekick (106a) and a left sidekick (106b), wherein the right sidekick (106a) extends from a right side of the at least one cabinet assembly (105) and includes at least one hook (164) for retaining a first side graphic, and wherein the left sidekick (106b) extends from a left side of the at least one cabinet assembly (105) and includes at least one hook (164) for retaining a second side graphic.

4. The mounting fixture of claim 3, wherein the at least one cabinet assembly (105) includes at least two cabinets (2) that are coupled to the beam (104) in a side-by-side arrangement, and wherein the right sidekick (106a) extends from a right side of one of the at least two cabinets (2) and the left sidekick (106b) extends from a left side of the other cabinet (2) of the at least two cabinets (2).

5. The mounting fixture of any one of claims 1-4, wherein each sidekick (106) includes a mounting member (161) and a receiving member (162) extending away from the mounting member (161) at an angle thereto, wherein the mounting member (161) is detachably coupled to the side of the cabinet assembly (105), wherein the receiving member (162) is made from a magnetic material to allow attachment of a magnetic static graphic as the at least one graphic, and wherein one of two opposing hooks (164) is provided on each of two opposite sides of the receiving member (162), such that an open section of each hook (164) receives one of the two opposite sides of the magnetic static graphic.

6. The mounting fixture of any one of the preceding claims, further comprising at least one topper (107) coupled to and extending upwardly from an upper portion of the at least one cabinet assembly (105).

7. The mounting fixture of claim 6, wherein the at least one topper (107) includes a right-side topper (107a) and a left-side topper (107b), wherein the right-side topper (107a) includes at least one hook (174) for retaining a first upper graphic, and wherein the left-side topper (107b) includes at least one hook (174) for retaining a second upper graphic.

8. The mounting fixture of any one of claims 6 and 7, wherein each topper (107) includes a mounting member (171) and a receiving member (172) extending away from the mounting member (171) at an angle thereto, wherein the mounting member (171) is detachably coupled to the upper portion of the cabinet assembly (105), and wherein the receiving member (171) includes two opposing hooks (174) with one hook (174) provided on each of a top edge and a bottom edge of the receiving member (172), such that an open section of each hook (174) receives a portion of the at least one graphic.

9. The mounting fixture of claim 8, wherein each receiving member (172) of each topper (107) further includes a side hook (175) that extends along a side of the respective receiving member (172), wherein the side hook (175) limits movement of the respective upper graphic beyond the side hook (175).

10. The mounting fixture of any one of claims 6-9, further comprising a gusset (108) coupling each topper (107) to the at least one cabinet assembly (105), wherein each gusset (108) includes a first wall (182), a second wall (183) provided at a right angle relative to the first wall (182), and a third wall (181) interconnecting the first (182) and second walls (183), wherein the first wall (182) is coupled to one of the topper (107) and the at least one cabinet assembly (105), and wherein the second wall (183) is coupled to the other of the topper (107) and the at least one cabinet assembly (105).

11. The mounting fixture of any one of the preceding claims, wherein the support post (103) includes:
a base plate (131) configured to attach to one of a foundation, another fixture, or the ground;
an upper plate (133) configured to support the beam (104); and
a tubular body (135) coupled to and extending between the base plate (131) and the upper plate (133).

12. The mounting fixture of any one of the preceding claims, wherein the beam (104) includes:
a tubular body (141); and
a mounting plate (142) coupled to a bottom surface of the body (141) of the beam (104), wherein the mounting plate (142) is also detachably coupled to the upper plate (133) of the support post (103).

13. The mounting fixture of one of claim 11 or claim 12, further comprising a junction box (138) coupled to the body (135) of the support post (103) or the beam (104), and wherein the junction box (138) is configured to house an electrical component.

14. The mounting fixture (101) of any one of the preceding claims, wherein the cabinet assembly (105) includes:
a cabinet (2) defining a cavity for receiving the at least one audio/visual device therein, wherein the cabinet (2) includes a front opening and a rear opening;
a door (1) coupled to the cabinet (2) and movable relative to the cabinet (2) between an open position providing access to the cavity via the rear opening and a closed position covering the rear opening; and
a transparent cover coupled to the cabinet (2) and covering the front opening.

15. The mounting fixture of claim 14, wherein the cabinet (2) includes a plurality of members (4, 5, 11) forming a cuboid outer frame surrounding the cavity, wherein the cabinet assembly (105) further includes a support assembly provided within the outer frame (4, 5, 11) and configured to provide structural support to the cabinet (2), wherein the support assembly includes at least one vertical brace (6) and at least one horizontal brace (7), wherein each brace (6, 7) of the support assembly is tubular and is coupled between two opposing members of the cabinet (2), and wherein each brace (6, 7) contacts the at least one audio/visual device.
